# EUROPEAN PATENT SPECIFICATION

(11) **EP 0 284 096 B1**
(45) Date of publication and mention of the grant of the patent: **03.02.1993**
(21) Application number: 88104857.3
(22) Date of filing: 25.03.1988
(51) Int. Cl.: H01B 12/00

(54) **Method of producing superconducting wire**
Verfahren zum Herstellen eines supraleitenden Drahtes
Procédé pour fabriquer un fil supraconducteur

(30) Priority: 27.03.1987 JP 74784/87
(43) Date of publication of application: 28.09.1988
(73) Proprietor: SUMITOMO ELECTRIC INDUSTRIES LIMITED, Osaka-shi, Osaka 541 (JP)
(72) Inventor: Saito, Shigeo, 1-3, Shimaya 1-chome, Konohana-ku, Osaka (JP)
(74) Representative: KUHNEN, WACKER & PARTNER

(56) References cited:
- DD-A- 102 017
- Shenoy et al.: "ternary Superconductors", Proceedings of the International Conference on Ternary Superconductors, 24-26 September 1980, Lake Geneva, USA
- Seeber et al.: "PbMo6S8: A new Generation of Superconducting Wires?" pages 119-124
- Wu et al.: "Superconductivity at 93K in a New Mixed-Phase Y-Ba-Cu-O Compund System at Ambient Pressure", vol. 58. no. 9, o9.03.87

## Description

### [Field of the Invention]

The present invention relates to a method of producing a superconducting wire, in particular to a method of producing a superconducting wire capable of obtaining a ceramics superconducting wire having a high critical temperature.

### [Prior Art]

The superconducting wire has been produced by turning a metallic superconductor (alloys, such as NbTi, and intermetallic compounds, such as Nb₂SN and V₃Ga) into a wire. However, their critical temperature (T_{c}) is 30K or less, so that they are poor in practical use. Accordingly, a superconductor having a high critical temperature has been desired.

And, a ceramics superconductor having a critical temperature of 30K or more has been recently developed.

### [Problems to be Solved by the Invention]

However, the above described ceramics superconductors have exhibited problems in that the workability is remarkably lowered due to the poor ductility and flexibility, so that they are very difficult to turn into a wire, and the constituent elements other than elements of the group IIa in the periodic table, elements of the group IIIa in the periodic table, copper and oxygen, which enter superconducting materials as impurities when sintered at high temperatures after giving a desired shape to them to obtain such ceramics conductors, have a bad influence upon superconducting characteristics such as critical temperature according to circumstances.

### [Object of the Invention]

The present invention was achieved in view of the above described problems.

It is an object of the present invention to provide a method of producing a superconducting wire in which there is not the possibility of having a bad influence upon superconducting characteristics and a ceramics superconducting wire having a high critical temperature can be obtained.

### [Measures for Solving the Problems]

In order to achieve the above described object, according to a method of producing a superconducting wire of the present invention, a ceramics superconducting material is coated with Cu-Be alloys and then turning into a wire material having an appointed shape followed by sintering said wire material at a temperature range, at which a superconducting layer can be formed, to obtain a superconducting wire with the superconducting layer coated with said alloys.

### [Operation]

According to a method of producing a superconducting wire having the above described construction, the Cu-Be alloys have a large ductility and a sufficient strength capable of standing up to the area-reduction processing, so that an outside force due to the processing in the area-reduction processing can be effectively transmitted to the internal superconducting material through the Cu-Be alloys as the coating, whereby the desired wire material can be obtained.

In addition, both Cu and Be can be elements composing the superconducting material, so that even though Cu and Be are diffused from the coating to enter the superconducting material when the wire material is sintered, there is not the possibility of having a bad influence upon the superconducting characteristics of the resulting superconducting wire.

### [Preferred Embodiment]

Next, one preferred embodiment of the present invention is described with reference to the drawings.
Fig. 1A to C is a sectional view showing respective processes, in which a superconducting wire is obtained according to a method of the present invention; and
Fig. 2 is a sectional view showing an application example of a superconducting wire.

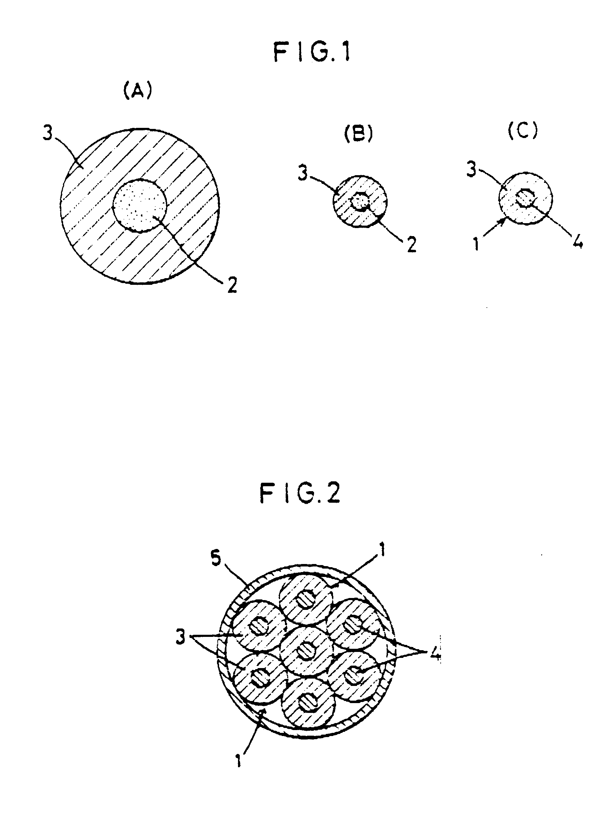

At first, a powdery mixture of a ceramics superconducting material (2) is filled in a cylindrical pipe formed of Cu-Be alloys (3) to obtain a double-layer material (hereinafter referred to as non-processed wire material) with the superconducting material (2) coated with the Cu-Be alloys (3), as shown in Fig. 1A.

Every material containing elements composing the superconducting material can be used as said superconducting material (2) regardless of elements and compounds. Said elements include elements of the groups I, II and III in the periodic table, oxygen, nitrogen, fluorine, carbon, sulfur and the like. In particular, said superconducting material (2) include at least one element selected from the group consisting of elements of the group Ia, elements of the group IIa and elements of the group IIIa in the periodic table, at least one element selected from elements of the group Ib, elements of the group IIb and elements of the group IIIb in the periodic table, and at least one element selected from the group consisting of oxygen, nitrogen, fluorine, carbon and sulfur. Of the above described elements of the group I in the periodic table, the elements of the group Ia include Li, Na, K, Rb, Cs, Fr and the like and the elements of the group Ib include Cu, Ag and Au. In addition, of the elements of the group II in the periodic table, the elements of the group IIa include Be, Mg, Ca, Sr, Ba and Ra and the elements of the group IIb include Zn, Cd and the like. Of the elements of the group III, the elements of the group IIIa include Sc, Y, lanthanoid elements, such as La, Ca, Pr, Nd, Pm, Sm, Eu, Gd, Tb, Dy, Ho, Er, Tm, Yb and Lu, actinoid elements, such as Ac, and the like. Besides, the elements of the group IIIb include Al, Ga, In, Tl and the like.

Of the above described elements, the elements selected from the group consisting of the elements of the group Ib, the elements of the group IIa, the elements of the group IIIa, lanthanoid elements and oxygen are preferably used. In addition, of the elements of the group Ib in the periodic table, Cu is in particular preferably used. In addition, of the elements of the group IIa in the periodic table, Sr, Ba and Be are preferably used. Of the elements of the group IIIa in the periodic table, Sc, Y and La are preferably used.

The above described elements themselves or compounds containing the above described elements are used singly or in combination in the form of powder and in the case where they are used in the form of compound, chlorides, nitrides and carbides may be used but oxides, carbonates, sulfides or fluorides are preferably used and oxides or carbonates are in particular preferably used. In addition, said powdery mixture may be composed of oxides or carbonates of the above described elements. In addition, the Cu-Be alloy (3) contains Be at a ratio of 0.01 to 5.0 % by weight. The ductility and the strength of the Cu-Be alloys is reduced and increased with an increase of a content of Be, respectively, but if Be is contained at the above described range, the ductility and strength sufficient for obtaining a long wire material having a small diameter by the area-reduction processing can be obtained.

Subsequently, the non-processed wire material is subjected to the area-reduction processing, such as extrusion, drawing and swaging, to obtain a long wire material having a small diameter as shown in Fig. 1B.

And, the resulting long wire material having a small diameter is sintered at a temperature range, at which the superconducting layer can be formed, to obtain the ceramics superconducting wire (1) with the superconducting layer (4) coated with said alloys (3) as shown in Fig. 1C. At this time, the Cu-Be alloys (3) are used as the coating, so that elements other than Cu and Be do not diffuse from said coating and do not enter the supercoating material. Accordingly, there is not also the possibility of having a bad influence upon the superconducting characteristics, such as critical temperature, of the resulting superconducting wire (1).

In addition, if it is intended to give a strength of the same degree as that of the Cu-Be alloys (3) by adding elements other than Be to the general Cu alloys, it is required to add said elements at a ratio of 10 % by weight or more. For example, the tensile strength and elongation of an annealed Cu-2 wt. % Be alloy material is 48 kg/mm² and 35 %, respectively. On the contrary, the tensile strength and the elongation of the general Cu-10 wt. % Ni alloy material is 30 kg/mm² and 42 %, respectively, and this alloy contains Ni which is an element belonging to the group VIIIa, so that there is the possibility of having a bad influence upon the superconducting characteristics. Accordingly, the Cu-Be alloys are preferably used as the coating.

In addition, as a rule the superconducting wire (1) is used with being coated with an insulating material (5). Fig. 2 is a sectional view showing one application example in which a bundle of a plurality of superconducting wires (1) is coated with the insulating material (5). The bundle of a plurality of superconducting wires (1) coated with the insulating material (5) is superior to one piece of superconducting wire (1) having the same sectional area in flexibility.

In addition, a method of producing the superconducting wire (1) according to the present invention is not limited to the above described preferred embodiment. For example, a measure for obtaining the non-processed wire material, in which a long rod having a small diameter formed of copper is inserted into a pipe formed of the Cu-Be alloys (3) and then the powdery mixture of the superconducting material (2) is filled in the circumference of said rod, may be used. In addition, a measure, in which a powdery mixture of the superconducting materials (2) is molded in columnar shape and the periphery of the resulting columnar molded product is coated with the Cu-Be alloys (3), may be used. In addition, a sectional shape of an inner circumferential surface and an outer circumferential surface of the pipe may be oval, rectangular and the like in addition to circular.

### [Experimental Example]

One experimental example of the superconducting wire obtained by the method of the present invention is below described.

A powdery mixture comprising Y₂O₃, BaCO₃ and CuO charged in a pipe of Cu-2%Be having an outside diameter of 20 mm and an inside diameter of 10 mm was subjected to the area-reduction processing. As a result, the powdery mixture could be turned into a wire having an outside diameter of 0.5 mm without breaking. The superconducting wire obtained by sintering the resulting wire material for 3 hours at 900°C was measured on the critical temperature with the result of T_{c}=45K. If sintering condition is made best fit, T_{c} is expected to further improve.

As above described, the superconducting wire having a diameter nearly same as that of the general wire can be obtained.

### [Effects of the Invention]

As above described, according to the method of producing a superconducting wire of the present invention, the ceramics superconducting materials are coated with the Cu-Be alloys, which are suitable for the area-reduction processing in respect of ductility and strength, so that the superconducting materials can be subjected to the area-reduction processing to obtain the long wire material having a small diameter. The resulting wire material can be sintered to easily obtain the superconducting wire. In addition, the Cu-Be alloys can be elements composing the superconducting materials, so that special effects are exhibited in that there is not the possibility of having a bad influence upon the superconducting characteristics and the ceramics superconducting wire having a high critical temperature can be obtained.

## Claims

1. A method of producing a superconducting wire, characterized by that a ceramics superconducting material is coated with Cu-Be alloys and then turned into a wire material having an appointed shape by the area-reduction processing followed by sintering said wire material at a temperature range, at which a superconducting layer can be formed, to obtain a superconducting wire with the superconducting layer coated with said alloys.

2. A method of producing a superconducting wire as set forth in Claim 1, wherein a Be-content in said Cu-Be alloys is 0.01 to 5.0 % by weight.

3. A method of producing a superconducting wire as set forth in Claim 1, wherein said superconducting materials comprise elements of the group IIa in the periodic table, elements of the group IIIa in the periodic table, copper and oxygen.

## Patentansprüche

1. Ein verfahren zum Herstellen eines supraleitenden Drahtes, dadurch gekennzeichnet, daß ein keramisches supraleitendes Material mit Cu-Be-Legierungen beschichtet und dann in ein Drahtmaterial umgewandelt wird mit einer angestrebten Form durch den Querschnittverringerungsprozeß gefolgt von Sintern des Drahtmateriales in einem Temperaturbereich, in welchem eine supraleitende Schicht gebildet werden kann, um einen supraleitenden Draht zu erhalten, bei dem die supraleitende Schicht mit den Legierungen beschichtet ist.

2. Ein Verfahren zum Herstellen eines supraleitenden Drahtes nach Anspruch 1, worin ein Be-Gehalt in den Cu-Be-Legierungen 0,01 bis 5,0 Gew.-% beträgt.

3. Ein Verfahren zur Herstellung eines supraleitenden Drahtes nach Anspruch 1, worin die supraleitenden Materialien Elemente aus der Gruppe IIa im Periodensystem, Elemente aus der Gruppe IIIa in dem Periodensystem, Kupfer und Sauerstoff aufweisen.

## Revendications

1. Un procédé de fabrication d'un fil supraconducteur, caractérisé en ce qu'un matériau supraconducteur en céramiques est revêtu d'alliages Cu-Be, et est ensuite transformé en un fil présentant la forme voulue par un traitement de réduction de surface, suivi d'un frittage dudit fil dans une plage de température pour laquelle une couche supraconductrice peut être formée, de façon à obtenir un fil supraconducteur présentant la couche supraconductrice revêtue desdits alliages.

2. Un procédé de fabrication d'un fil supraconducteur selon la revendication 1, dans lequel la teneur en Be dans lesdits alliages Cu-Be est de 0,01 à 5,0% en poids.

3. Un procédé de fabrication d'un fil supraconducteur selon la revendication 1, dans lequel lesdits matériaux supraconducteurs comprennent des éléments du groupe IIa du tableau périodique, des éléments du groupe IIIa du tableau périodique, du cuivre et de l'oxygène.
